# EUROPEAN PATENT APPLICATION

(11) **EP 4 576 569 A1**
(43) Date of publication of application: **25.06.2025**
(21) Application number: 24219596.4
(22) Date of filing: 12.12.2024
(51) Int. Cl.: H03F 1/02, H03F 3/195, H03F 3/213

(54) **TRANSISTOR CIRCUITS WITH INDEPENDENTLY BIASED FIELD PLATES**

(30) Priority: 21.12.2023 US 202318392797
(71) Applicant: NXP USA, Inc., Austin, TX 78735 (US)
(72) Inventor: Hill, Darrell Glenn, 5656 AG Eindhoven (NL)
(74) Representative: Hardingham, Christopher Mark

(57) **Abstract**

Improved transistor performance for RF switching and amplification can be achieved by providing a transistor such as a electron mobility transistor with one or more field plate electrodes coupled to the channel of the transistor that can be biased independently of the gate electrode and the current terminals of the transistor. For example, when the field plate electrode(s) are biased to at least partially deplete the channel near the field plate electrode(s), the breakdown voltage characteristics of the transistor can be improved. In RF applications, circuitry that biases the field plate electrodes can be powered by RF signals already present in the circuitry in which the transistor is incorporated, removing the need to provide a separate bias voltage source for the field plate electrode(s).

## Description

### TECHNICAL FIELD

Embodiments of the subject matter described herein relate to transistors and transistor circuits.

### BACKGROUND

High electron mobility transistors (HEMTs) typically operate in a depletion mode in which the transistor channel is electrically conductive when no bias voltage is applied to the gate. The channel conductivity is controlled by applying a negative bias voltage to the gate. Such depletion-mode transistors are often used in applications requiring high power handling and large drain-to-source breakdown voltage. In such devices, one or more additional electrodes ("field plates") are often present above the channel in between the gate and drain terminals in order to reduce large electric potential gradients that can occur near edges of the gate electrode in order to improve the breakdown voltage of the device. These field plates are typically electrically coupled to the source terminal of the transistor.

### SUMMARY

In an example embodiment, an electronic device includes an input node, an output node, a transistor, and field-plate bias circuity. The transistor includes a first current terminal that is coupled to the output node; a second current terminal; a semiconductive channel region disposed between the first current terminal and the second current terminal; a gate electrode electrically coupled to the semiconductive channel region and coupled to the input node; and a field plate electrode electrically coupled to the semiconductive channel region and disposed adjacent to the gate electrode. The field plate bias circuitry coupled to the field plate electrode and configured to apply a desired field plate bias voltage to the field plate electrode that at least partially depletes the channel region of charge carriers near the field plate electrode.

In another example embodiment, an amplifier device also includes an input node, an output node, a transistor; and field plate bias circuitry. The input node configured to receive a radiofrequency (RF) input signal and the output node is configured to output an amplified signal corresponding to the RF input signal. The transistor is configured to amplify the RF input signal and the transistor includes a first current terminal; a second current terminal; a semiconductive channel coupled between the first current terminal and the second current terminal; a gate electrode disposed between the first current terminal and the second current terminal and coupled to the semiconductive channel. The gate electrode is configured to modulate an output of the transistor in response to the RF input signal; and the transistor also includes a field plate electrode that is adjacent to the gate electrode and also coupled to the semiconductive channel. The field-plate bias circuity coupled to the field plate electrode and configured to apply a desired field plate bias voltage to the field plate electrode that at least partially depletes the channel region of charge carriers near the field plate electrode.

In another example embodiment, a Doherty amplifier includes an input node configured to receive a radiofrequency (RF) input signal; an output node configured to output an amplified signal corresponding to the RF input signal; a carrier amplifier signal path; a peaking amplifier signal path; and field plate bias circuitry. The carrier amplifier signal path includes a first transistor configured to amplify the RF input signal over a first input power range of the RF input signal. The peaking amplifier signal path includes a second transistor configured to further amplify the RF input signal over a second input power range of the RF input signal.

The first transistor includes a first current terminal; a second current terminal; a semiconductive channel coupled between the first current terminal and the second current terminal; a gate electrode disposed between the first current terminal and the second current terminal and coupled to the semiconductive channel and configured to modulate an output of the transistor in response to the RF input signal; and a field plate electrode that is adjacent to the gate electrode and also coupled to the semiconductive channel.

The second transistor includes a first current terminal; a second current terminal; a semiconductive channel coupled between the first current terminal and the second current terminal; a gate electrode disposed between the first current terminal and the second current terminal and coupled to the semiconductive channel and configured to modulate an output of the transistor in response to the RF input signal; and a field plate electrode that is adjacent to the gate electrode and also coupled to the semiconductive channel.

The field-plate bias circuity is coupled to the field plate electrodes of the first transistor and the second transistor and is configured to apply a desired first field plate voltage to the field plate electrode of the first transistor and to apply a desired second field plate voltage to the field plate electrode of the second transistor. The desired first and second field plate voltages are configured to at least partially deplete the channel regions of the first transistor and the second transistor of charge carriers near the field plate electrodes of the first and second transistors, respectively.

### BRIEF DESCRIPTION OF THE DRAWINGS

The present disclosure is illustrated by way of examples, embodiments and the like and is not limited by the accompanying figures, in which like reference numbers indicate similar elements. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIG. 1 is a circuit schematic of an integrated circuit according to one or more embodiments herein.
FIG. 2 is a schematic cross-sectional view of a transistor suitable for use in one or more embodiments.
FIG. 3 is a top plan view of a transistor with integrated field plate bias circuitry according to one or more embodiments.
FIG. 4 is a block-level schematic of a Doherty amplifier circuit that includes field plate bias circuitry according to one or more embodiments.

### DETAILED DESCRIPTION

The following detailed description provides examples for the purposes of understanding and is not intended to limit the invention or the application and uses of the same. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring the invention. Additionally, elements in the drawing figures are not necessarily drawn to scale. For example, the dimensions of some of the elements or regions in the figures may be exaggerated relative to other elements or regions to help improve understanding of embodiments of the invention.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose.

Directional references such as "top," "bottom," "left," "right," "above," "below," and so forth, unless otherwise stated, are not intended to require any preferred orientation and are made with reference to the orientation of the corresponding figure or figures for purposes of illustration.

It will be appreciated that the steps of various processes described herein are non-limiting examples of suitable processes according to embodiments and are for the purposes of illustration. Systems and devices according to embodiments herein may be use any suitable processes including those that omit steps described above, perform those steps and similar steps in different orders, and the like. It will also be appreciated that well-known features may be omitted for clarity.

It will be understood that references herein to radio-frequency (RF) signals and radio-frequency devices are not intended to limit embodiments herein to operation at any particular frequency or frequency range. For example, as used herein, radio-frequency may refer to time-varying signals in any suitable frequency bands including, but not limited to, microwave frequencies (~300MHz - 300 GHz), millimeter-wave frequencies (i.e., 30-300 GHz), and others.

It will be appreciated that although current terminals of transistors described herein may be referred to by conventional names associated with field effect transistors and the like such as "source" and "drain," embodiments herein can employ any suitable transistor technologies, including those in which the terms "source" and "drain" are not used. It will be further understood that source and drain terminals may be interchangeable, depending on how a transistor is connected within a larger circuit.

Radio-frequency (RF) power transistors and other high-frequency power transistors used in amplifier applications commonly use a source-connected field plate to modify the field between the gate and the drain. For GaN high electron mobility transistors (HEMTs), an important function of this field plate is to deplete the channel adjacent to the gate for reduced gate-drain capacitance (C_{GD}); this depletion and associated C_{GD} reduction are necessary to achieve competitive gain. The design of the field plate inherently involves many trade-offs among performance, reproducibility, manufacturability, and gate-drain vs. gate-source capacitance.

As one example trade-off, the ability of the field plate to deplete the channel between the gate and the drain depends on the thickness of the dielectric between the field plate and the channel. Decreasing the dielectric thickness improves the ability to deplete the channel, but it also increases undesirable drain-source capacitance (C_{DS}); and in most GaN HEMT process flows, it also introduces additional undesirable gate-source capacitance (C_{GS}). The C_{DS} trade-off can be somewhat mitigated by decreasing the length of the field plate as the dielectric thickness is decreased; however, as field plate length is reduced, manufacturability and reproducibility become more challenging. If another degree of freedom could be introduced into the design to mitigate such fundamental trade-offs, then channel depletion under the field plate could be achieved with reduced C_{DS} and C_{GS}, thereby delivering significantly improved performance. Being able to independently control the electrical potential of a field plate electrode can introduce an additional degree of freedom that can enable various advantages described further below. However, previous circuit designs can have shortcomings which must be overcome. First, existing circuit designs do not typically include a connection for supplying a field-plate voltage which is different from the source, gate, and drain voltages. Furthermore, providing a distinct potential for the field plate externally (i.e., from outside the package) would require a separate lead in a product package. In addition, high power HEMTs typically employ multiple parallel "fingers" in order to support large currents. If there are more than two such fingers, then distributing this distinct potential evenly throughout the die to all the individual field plate fingers of the device may not be practical in typical compound semiconductor technologies (such as GaN and GaAs), which generally have only one or two levels of interconnect metal. In such technologies, distribution of the distinct field plate potential would require signal crossovers, which would introduce undesirable parasitic capacitances and complex feedback paths. One solution would be to add another layer of interconnect metal. This would reduce undesired parasitic capacitance, but with some increase in process cost and complexity.

Although circuits with additional input connections to support controlling field plate voltages are possible, such circuits would introduce added complexity for circuit designers and end-users. One solution to this problem would be to include an additional bias generation circuit in packaged devices that can generate the necessary negative voltages to drive an independent field plate, using a charge pump driven by an oscillator circuit. However, charge pumps inevitably introduce noise at their operating frequency, and steps would have to be taken to filter out this noise, adding even more cost and complexity. Furthermore, such an approach would also not address the problem of distributing the negative potential evenly throughout power transistor die that do not ordinarily include multiple interconnect layers.

Accordingly, devices and methods according to embodiments herein allow for radio-frequency, microwave and other high-frequency transistor circuits (including HEMT-based circuits) which take advantage of time-varying output voltages present during operation of RF amplifier and switch circuits to power a negative-voltage supply suitable for control of a field plate without introducing excessive noise or requiring excessive power consumption.

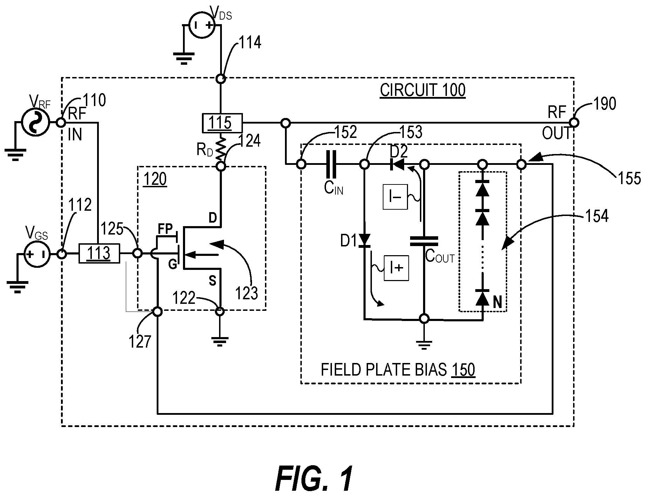

FIG. 1 is a circuit diagram of an example circuit that includes a self-biased field plate according to one or more embodiments. The circuit 100 is configured for use as a radio frequency (RF) amplifier circuit and includes an input port 110 (labeled "RF IN") configured to receive time-varying input signals and an output port 190 (labeled "RF OUT") configured to output an amplified signal corresponding to the input signal. The circuit 100 also includes a gate bias input 112 and a drain bias input 114. The circuit 100 includes a transistor 120 that includes has a first current terminal (i.e., the drain 124), and a second current terminal (i.e., the source terminal 122) separated by a semiconductive channel region 123. A resistor R_{D} represents the output resistance of the transistor 120. The transistor 120 has a first control terminal that is electrically coupled to a semiconductive channel region 123 (i.e., the gate 125) and a second control terminal (i.e., the field plate 127) that is also electrically coupled to the semiconductive channel region 123 and disposed between the gate 125 and the drain 124.

The gate 125 of the transistor 120 is configured to receive a gate bias ("V_{GS}") via the gate bias input 112. A radio frequency (RF) input signal (denoted "V_{RF}") can be superimposed on the gate bias. As shown, the signals received at the inputs 110, 112 can be combined via coupling circuitry 113 (e.g., a bias tee circuit) which can form part of the circuit 100 or can be external to the circuit 100. A DC drain bias voltage ("V_{DS}") can be applied to the drain 124 of the transistor 120 via the drain bias input 114. As shown, the drain bias V_{DS} can be applied to the drain bias input 114 without affecting the output port 190 using coupling circuitry 115 (e.g., a bias tee circuit) which can form part of the circuit 100 or can be external to the circuit 100.

In the example of FIG. 1, the transistor 120 is operated in a common source configuration in which the source terminal is grounded. As a result, voltages described as negative in connection with the circuit 100 are those that are less than the electric potential of the source terminal 122. It will be understood that nothing herein is intended to require an absolute reference potential value. It will also be understood that nothing herein is intended to limit embodiments herein to transistors operated in a common source configuration or analogous configurations.

The circuit 100 also includes field plate bias circuitry 150 coupled between the drain 124 (which is coupled to the output port 190 of the circuit 100) and the field plate 127 of the transistor 120. The field plate bias circuitry 150 is capacitively coupled to the output of the transistor 120 at the input node 152 of the field plate bias circuitry 150. The output node 155 of the field plate bias circuitry 150 is coupled to the field plate 127 of the transistor 120. The field plate bias circuitry 150 is configured to "harvest" electrical energy from the time-varying output of the transistor 120 and to use that energy to develop a constant negative voltage sufficient to bias the field plate 127 at the output node 155 of the field plate bias circuitry 150, so long as the signal amplitude at the output node 190 of the circuit is sufficiently large.

The field plate bias circuitry 150 of FIG. 1 is a non-limiting example e of circuitry suitable for use as a field plate bias circuit. It will be understood that any suitable circuitry or other devices can be used in embodiments herein. In this example, the input capacitance ("C_{IN}") is coupled to an output capacitance ("C_{OUT}") by voltage rectifying elements (diodes D1 and D2 in this example) in a charge-pump configuration. When the AC-coupled voltage at the node 153 is negative relative to the reference potential ("ground"), current flows out of C_{OUT} through D2, causing a negative voltage to develop across G_{OUT}. Meanwhile, when the AC-coupled voltage at the node 153 is positive relative to the reference potential, current is shunted to ground through D1, while D2 is turned off, preventing C_{OUT} from being discharged. An overvoltage regulation element 154 is configured to cause C_{OUT} to be partially discharged to ground if the negative voltage across C_{OUT} becomes more negative than the desired negative voltage at the output node 155 of the field plate bias circuitry 150. In this example, the overvoltage regulation element 154 is a set of *N* diodes connected in series. If the forward turn-on voltage of each diode is *V_{F},* then the negative voltage at the output node 155 will not become more negative with respect to the reference potential than -(*N*×*V_{F}*)*.*

Field plate bias circuitry such as the field plate bias circuitry 150 can be operating using a small fraction of the RF power generated at the output node 190 of a circuit such as the circuit 100. For example, in a representative GaN HEMT with 1 mm of gate periphery, operated at 48 V, the RF output power may be 5 W with an RF input power of 50 mW, and with average drain current of 170 mA, corresponding to a power-added efficiency ("PAE") of 60.66%. Meanwhile the additional current consumption of integrated field plate bias circuitry such as the field plate bias circuitry 150 can be well below 0.1 mA. In this example, if a worst-case value of 0.1 mA is assumed, the PAE would be reduced from 60.66% to 60.63%, which is a negligible reduction for many applications.

It will be appreciated that the simple voltage regulation approach illustrated in FIG. 1 can be modified to allow the desired output voltage at the output node 155 to be controlled. For instance, switching elements can be applied to bypass one or more diodes of the overvoltage regulation element 154 of the field plate bias circuitry 150, allowing desired negative output voltage to be adjusted in increments of V_{F}. It will further be understood that any other suitable circuits and techniques can be used in embodiments herein to provide for a variable negative voltage at the output node 155 of the field plate bias circuitry 150.

The desired output voltage of field plate control circuitry such as the field plate bias circuitry 150 can be varied based on the amplitude of the RF output signal at the output of a transistor circuit such as the circuit 100 or by an externally-supplied control signal, as nonlimiting examples. In such embodiments, the field plate potential can be used to dynamically modify the operating characteristics of a transistor such as the transistor 120 during operation of the circuit 100 to achieve desired operating characteristics for different scenarios. For example, it may be desirable in certain applications to flatten the gain curve of a transistor such as the transistor 120 or to tune output phase modulation response to input amplitude modulation (AM-PM) characteristics of the transistor to achieve improved output power linearity over a given range of output power levels As another example, it can be desirable in certain applications to increase the transistor output gain under low drain bias voltage (V_{DD}) conditions to support drain modulation for improved efficiency, and so on.

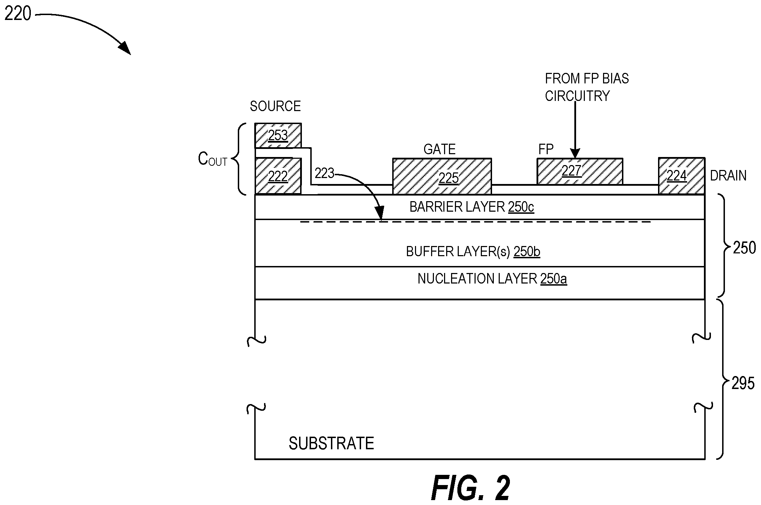

In one or more embodiments, a transistor such as the transistor 120 is a high electron mobility transistor (HEMT) in which a two-dimensional electron gas ("2DEG") forms a conductive channel controlled by a first control terminal (e.g., a gate 125 or gate electrode 125) and a second control terminal (i.e., the field plate 127 or field plate electrode 127). FIG. 2 is simplified cross-sectional view of a HEMT 220. The cross-section shown passes through a drain electrode 224, a gate electrode 225, a field plate electrode 227, and a source electrode 222. As shown, the field plate electrode is configured to receive bias voltage input from field plate bias circuitry such as the field plate bias circuitry 150. In one or more embodiments, an additional electrode or other conductive feature forms part of field plate control circuitry such as the field plate bias circuitry 150. In the example of FIG. 2, the electrode 252 separated from source electrode 222 by a dielectric material forms a capacitor (e.g., the capacitance C_{OUT} of the field plate bias circuitry 150).

In this simplified example, a channel region 250 is formed on or within a substrate 295 from a semiconductor heterostructure that includes three layers which will be described in the context of a GaN HEMT as an example. The channel region 250 is formed from a nucleation layer 250a (e.g., a layer of aluminum nitride), followed a by a buffer layer 250b (e.g., an epitaxial layer of gallium nitride or multiple epitaxial layers), and a barrier layer 250c (e.g., an insulating aluminum nitride/gallium nitride alloy). A 2DEG 223 is formed at the interface between the buffer layer 250b and the barrier layer 250c. Typically, for GaN HEMT devices, the substrate 295 may be silicon, silicon carbide, sapphire or any other suitable material. In areas where the presence of a conductive 2DEG is not desirable, one or more of the layers of the channel region 250 can be modified to prevent formation of the 2DEG, rendering the area highly resistive or electrically insulating using any suitable methods, including lithographic patterning, doping, and/or disruption of interfaces via ion implantation, as nonlimiting examples.

In one or more embodiments, additional circuit elements (e.g., all or part of a field plate bias circuit such as the field plate bias circuit 150) are integrally formed within the same substrate as a transistor such as the transistor 220 (e.g., a transistor 120). For example, it will be appreciated that capacitors and diodes can be formed by selectively patterning one or more layers formed on or within a substrate such as the substrate 295 to form capacitors, diodes, and the like. It will be further appreciated that such structures can also be formed by any suitable combination of semiconductor materials and metals. For instance, Schottky diodes may be formed at a suitable metal-semiconductor interface.

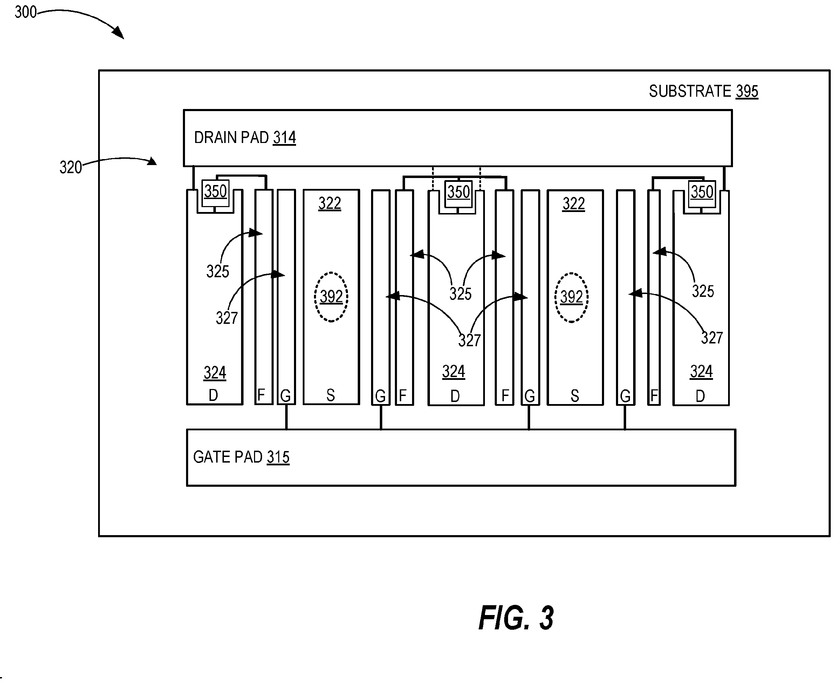

FIG. 3 is a top plan view of an example integrated circuit according to one or more embodiments in which a transistor is provided with integrated field plate bias circuits (e.g., field plate bias circuit 150). The integrated circuit 300 is formed on a substrate 395 that is completely or partially composed of a semiconductor material such as silicon, silicon carbide (SiC), or other suitable semiconductor materials. In one or more other embodiments, a substrate such as the substrate 395 includes other materials such as sapphire, silicon (Si), gallium nitride (GaN), aluminum nitride (AIN), diamond, boron nitride (BN), poly-SiC, silicon on insulator, gallium arsenide (GaAs), indium phosphide (InP), and/or other substantially insulating or high resistivity materials.

The integrated circuit 300 includes a transistor 320 (e.g., a transistor 120 or 220). As shown, the transistor 320 is a field effect transistor (FET) defined by multiple segments forming terminals of the device ("fingers"). The transistor 320 has source fingers 322 (`S'), drain fingers 324 (`D'), gate fingers 325 (`G'), and field plate fingers 327 (`F'). Each of the source fingers 322, the drain fingers 324, the gate fingers 325, and the field plate fingers 327 are respectively formed from conductive material (e.g., gold, copper, titanium, aluminum, nickel, and/or the like) disposed at a first surface of the substrate 395. The drain fingers 324 of the transistor 320 are electrically coupled to a drain pad 314 (e.g., a drain bond pad) and the gate fingers 325 are electrically coupled to a gate pad 315 (e.g., a gate bond pad). It will be appreciated that these fingers are coupled to corresponding portions of the transistor 320 operable as a source, gate, field plate, and drain.

In this example, the source fingers 322 of the transistor 320 are electrically coupled to a layer of electrically conductive material (a "reference plane," not shown), that is disposed at a second surface of the substrate 395 and that, during operation, is configured to be biased to a reference potential ("ground)". The source fingers 322 of the transistor 320 are electrically coupled to the reference plane by through-substrate vias (TSVs) 392. Each TSV 392 corresponds to an opening (e.g., hole) in the substrate 395 that extends between one of the source fingers 322 and the reference plane and that includes conductive material that provides an electrical connection between that source fingers 322 and the reference plane.

The transistor 320 also includes discrete field plate bias circuits 350 (e.g., field plate bias circuits 150) distributed across the substrate 395, with each field plate bias circuit 350 coupled to a pair of adjacent field plate fingers 327 or a single field plate finger 327. The use of individual field plate bias circuits 350, each coupled to a small number of field plate fingers 327 (or one such finger) can help reduce the likelihood that field plate fingers are biased non-uniformly across the substrate 395. As illustrated by FIG. 3, field plate bias circuits such as the field plate bias circuits 350 can be integrated into existing transistor designs without increasing the total footprint of the transistors on a substrate. It will be appreciated that circuits according to embodiments herein can have any suitable number of source, drain, gate, and field plate fingers. Along these lines, individual field plate bias circuits according to embodiments herein can be coupled to any suitable number of field plate fingers, subject to design rules and desired performance characteristics.

In one or more embodiments, field plate bias circuitry (e.g., the field plate bias circuitry 150 and/or field plate bias circuits 350) is capacitively coupled to the output of a transistor such as a transistor 120, 220 or 320. In the example of a GaN HEMT such as the transistor 220 or 320, conductive material under portions of the drain fingers (e.g., drain fingers 324) or the drain pad (e.g., the drain pad 314) can form an input capacitance for the field plate bias circuitry (e.g., the input capacitance C_{IN} of the field plate bias circuitry 150). Along these lines, diodes (e.g., the diodes D1 and D2 of the field plate bias circuitry 150) and a separate capacitor can be connected to the conductive material forming part of the input capacitance in such a way that the time-varying potential on a drain pad (e.g., the drain pad 314 during normal RF operation of the transistor 320) results in a negative potential across the output capacitance (i.e.,, the output capacitance C_{OUT} of the field plate bias circuitry 150 in this example). The negative voltage across the output capacitance is, in turn, supplied to a second portion of the circuit or circuits (e.g., the over-voltage regulation element 154 of the field plate bias circuitry 150, represented by a string of diodes in FIG. 1) which regulates the negative voltage to the desired level and supplies the desired negative field plate bias voltage to one or more field plates (e.g., a field plate 127, a field plate 227, or one or more field plate fingers 327).

It will be appreciated that transistor circuits with integrated field plate control circuitry according to embodiments herein (e.g., field plate bias circuitry 150, 350) can have various desirable characteristics and advantages over previous approaches which require dedicated oscillator circuits and/or those which require an externally supplied field plate bias signal. For instance, because field plates in embodiments herein have no DC connection to the current-carrying portions of a device, such as the circuit 100 or the circuit 300, such field plates only require an amount of DC current sufficient to offset leakage currents within the input capacitance of the field plate bias circuitry (e.g., the input capacitance C_{IN} of the circuit 100). When the input capacitance is implemented as a metal-insulator-metal capacitor (e.g., as described above in connection with the circuit 300 of FIG. 3), these currents can safely be assumed to be in the µA / mm range as long as the field plate potential stays well below the breakdown voltage of the input capacitance (typically > 100 V). Because this current is many orders of magnitude below the RF drain current in a power FET such as the transistor 120, 220, or 320, but at the same frequency, additional noise attributable to this current is insignificant compared to existing noise present at the output during operation.

Incorporation of the output capacitance of field plate bias circuitry (C_{OUT}) into one or more source fingers in a circuit such as the circuit 300 means that no additional inductance is added to any field plate compared to previous approaches that lack field plate bias circuitry such as the field plate bias circuitry 150 or 350. Moreover, this lack of additional inductance makes this approach more attractive than having the field plates of the circuit 300 controlled by an externally supplied voltage, since additional inductance would be introduced by the presence of additional leads and signal lines.

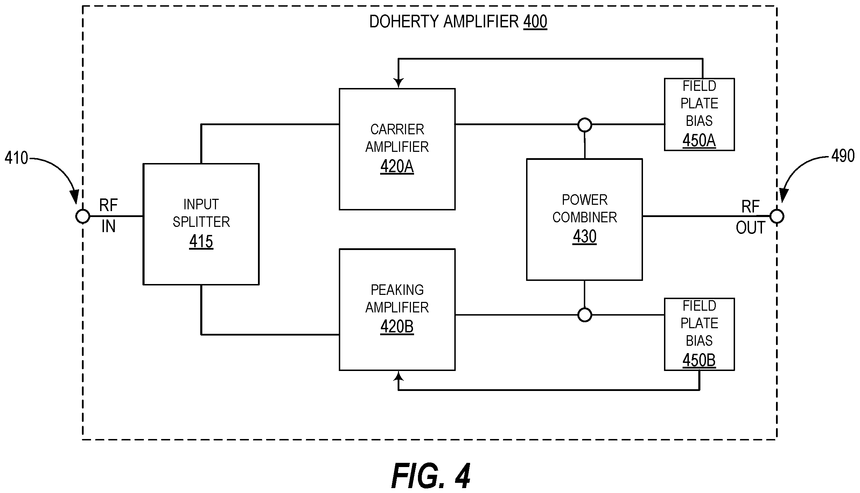

Transistors and field plate bias circuitry according to embodiments herein are suitable for use in a variety of circuits, including both single-path amplifier circuits and Doherty amplifier circuits which include a carrier amplifier path configured to amplify an RF input signal when the input signal is within a first power range and a peaking amplifier path configured to amplify the input signal when the input power increases beyond the first power range. FIG. 4 shows a simplified block diagram of a Doherty amplifier circuit 400 that includes an RF input 410 and an RF output 490. An RF input signal is coupled to a carrier amplifier 420A and a peaking amplifier 420B via an input splitter 415. The outputs of the carrier amplifier 420A and the output of the peaking amplifier 420B are coupled to the RF output 190 via a power combiner 430. In this example the carrier amplifier 420A and the peaking amplifier 420B include transistors according to embodiments herein (e.g., transistors 120, 220, or 320) provided with field plates (e.g., field plates 127, 227 and/or field plate fingers 327). Field plate bias circuitry 450A (e.g., field plate bias circuitry 150 or 350) is coupled to the output node of carrier amplifier 420A and provides a negative field plate bias voltage to the transistor(s) of the carrier amplifier 420A. Field plate bias circuitry 450B (e.g., field plate bias circuitry 150 or 350) is coupled to the output node of peaking amplifier 420B and provides a negative field plate bias voltage to the transistor(s) of the peaking amplifier 420B.

Embodiments herein can be applied to both single-ended amplifier devices and Doherty amplifier devices such as the Doherty amplifier circuit 400, even where backed-off operation is typical. As one example, a representative carrier amplifier such as the carrier amplifier 420A biased at V_{DD} = 48 V can produce a peak-to-trough voltage swing of approximately 28 V at 10 dB below saturation. Since charge pumps are able to deliver a potential offset equal to the amplitude of the peak-to-trough swing minus any applicable diode voltage drops, a target potential as large as -25 V is achievable under backed-off operation of a carrier device such as the carrier amplifier 420A. This is because the input capacitance of field plate bias circuitry (e.g., as the field plate bias circuitry 150, 350, 450) can be configured to maintain a desired negative voltage output for periods of time where output power may be significantly lower than 10 dB below saturation, limited only by leakage of its input capacitance.

Embodiments herein are also suitable for use with peaking amplifier devices such as the peaking amplifier 420B as well, which can enable improved bandwidth due to improved C_{DS} that results from a negatively biased field plate. Although the peaking amplifier in a Doherty amplifier is frequently off, the output of a Doherty amplifier is coupled to the outputs of both the carrier amplifier and the peaking amplifier (see the carrier amplifier 420A and peaking amplifier 420B coupled to the power combiner 430). As a result, when field plate bias circuitry such as the field plate bias circuitry 150, 350, 450A, 450B is coupled to the output node of a Doherty amplifier, the field plate bias circuitry can supply a suitable negative bias voltage to transistors used in a peaking amplifier using output power generated by the carrier amplifier, even when the input signal lacks the amplitude necessary to turn on the peaking amplifier.

Accordingly, it will be understood that a Doherty amplifier according to embodiments of this disclosure can include one or more transistors with field plate bias circuitry (e.g., field plate bias circuitry 150, 350, or 450) in the peaking signal path, the carrier signal path, or both signal paths (e.g., Doherty amplifier can be modified to omit the field plate bias circuit 450A or to omit the field plate bias circuitry 450B). Such field plate bias circuitry can be powered using any suitable power source. For example, in one or more embodiments, field plate bias circuitry is powered directly by the RF output of a transistor to which it is coupled. Meanwhile, in one or more other embodiments, the field plate bias circuitry is powered by another RF output signal. For example, the Doherty amplifier 400 could be modified to couple the field plate bias circuitry 450A to the RF output node 490 rather than directly to the output of the carrier amplifier 420A. Similarly, the Doherty amplifier 400 could be modified to couple the field plate bias circuitry 450B to the RF output node 490 rather than directly to the output of the carrier amplifier 420B.

It will be understood that although embodiments herein may be described with reference to particular transistor circuits or particular transistor types (e.g., common-source transistor circuits and n-type HEMTs operated as depletion-mode devices in which the channel region is electrically conductive unless a suitable bias is applied to deplete the channel), that nothing herein is intended to limit embodiments to any specific circuit topology or transistor type. For instance, in one or more embodiments, a p-type depletion-mode transistor is used rather than an n-type device and it will be understood that, in such embodiments, the voltages applied to the gate electrode of such a transistor and to the field plate electrode of that transistor would be conventionally described as positive relative to the electric potential of the source terminal or other reference potential. Similarly, in one or more embodiments, a transistor is operated as an enhancement mode device rather than a depletion mode device. In such embodiments, it will be appreciated that the bias applied to the gate of the transistor will have a polarity that is opposite the polarity of the field plate electrode because the overall conductivity of the channel is modulated by a gate voltage configured to increase the carrier concentration in the channel while the field pate electrode should be biased to reduce carrier concentration (i.e., at least partially deplete the channel) in the vicinity of the field plate electrode in order to realize improved breakdown voltage characteristics of the device.

It will be further understood that field plate electrodes according to embodiments herein can be biased by any appropriate bias source. For example, field plate bias circuitry according to embodiments can include any suitable DC voltage source. As a further example, field plate bias circuitry according to embodiments can be powered by an external RF signal or by an RF signal generated by a source other than a transistor or other device to which the field plate bias circuitry is directly coupled.

### VARIOUS EXAMPLES

Features of embodiments may be understood by way of one or more of the following examples: Formalized claim summaries will be inserted here upon approval of the claims.

Example 1: A device or method of fabricating a device that includes: an input node and an output node; a transistor and field-plate bias circuity. The transistor includes a first current terminal that is coupled to the output node; a second current terminal; a semiconductive channel region disposed between the first current terminal and the second current terminal; a gate electrode electrically coupled to the semiconductive channel region and coupled to the input node; and a field plate electrode electrically coupled to the semiconductive channel region and disposed adjacent to the gate electrode. The field plate bias circuitry coupled to the field plate electrode and configured to apply a desired field plate bias voltage to the field plate electrode that at least partially depletes the channel region of charge carriers near the field plate electrode.

Example 2: The device or method of Example 1 where the field plate electrode is disposed between the gate electrode and the first current terminal.

Example 3: The device or method of Example 1 or Example 2, where the field plate bias circuitry is coupled between the second current terminal and the output node and the field plate bias circuitry is configured to generate the field plate bias voltage to the field plate electrode in response to a time-varying voltage at the output node.

Example 4: The device or method of any one of Examples 1-3, where the field plate bias circuitry includes a charge pump circuit that is powered by the time-varying voltage at the output node and configured to generate the desired field plate bias voltage.

Example 5: The device or method of any one of Examples 1-4, where the transistor and at least part of the field plate bias circuitry are integrally formed within semiconducting material of a single semiconductor substrate.

Example 6: The device or method of any one of Examples 1-5, where the field plate bias voltage is generated by the field plate bias circuitry in response to the time-varying voltage at the output node having at least a predetermined minimum amplitude.

Example 7: The device or method of any one of Examples 1-6 where the transistor includes at least first and second drain fingers coupled to the first current terminal; first and second source fingers coupled to the second current terminal; first and second gate fingers coupled to the first control terminal; and first and second field plate fingers; and where the field plate bias circuitry include: a first field plate bias circuit coupled to the first field plate finger and configured to supply a first predetermined field plate finger bias voltage to the first field plate finger; and a second field plate bias circuit coupled to the second field plate finger and configured to supply a second field plate finger bias voltage to the second field plate finger.

Example 8: The device or method of any one of Examples 1-7, where the first field plate finger bias voltage is equal to the second field plate finger bias voltage.

Example 9: The device or method of any one of Examples 1-8, where the first field plate bias circuit includes an input capacitance that couples the first drain finger to the first field plate bias circuit.

Example 10: The device or method of any one of Examples 1-9, where the first field plate bias circuit includes an output capacitance coupled between the first source finger and the first field plate finger; where the output capacitance of the first bias field plate bias circuit has a first capacitor terminal formed by at least a portion of the first source finger.

Example 11: The device or method of any one of Examples 1-10, where the transistor is a high electron mobility transistor (HEMT) and the channel region include a semiconductor heterostructure configured to form a two-dimensional electron gas (2DEG) at a buried semiconductor heterojunction within the semiconductor heterostructure.

Example 12: The device or method of any one of Examples 1-11, where field plate bias circuitry include: an input capacitance and an output capacitance; where the input capacitance is coupled between the first current terminal and the output capacitance; where the output capacitance is coupled between the output node of the field plate bias circuitry and a reference potential node.

Example 13: The device or method of any one of Examples 1-12, where field plate bias circuitry further include: voltage regulation circuitry is configured to prevent a magnitude of a voltage across the output capacitance from exceeding the desired field plate bias voltage.

Example 14: The device or method of any one of Examples 1-13, where the field plate bias circuitry is configured to cause an electric potential of the field plate electrode to be lower than respective electric potentials of the first current terminal, the second current terminal, and the gate electrode.

Example 15: A device or method of forming a device that includes: an input node configured to receive a radiofrequency (RF) input signal; an output node configured to output an amplified signal corresponding to the RF input signal; a carrier amplifier signal path; a peaking amplifier signal path; and field plate bias circuitry. The carrier amplifier signal path includes a first transistor configured to amplify the RF input signal over a first input power range of the RF input signal. The peaking amplifier signal path includes a second transistor configured to further amplify the RF input signal over a second input power range of the RF input signal.

The first transistor includes a first current terminal; a second current terminal; a semiconductive channel coupled between the first current terminal and the second current terminal; a gate electrode disposed between the first current terminal and the second current terminal and coupled to the semiconductive channel and configured to modulate an output of the transistor in response to the RF input signal; and a field plate electrode that is adjacent to the gate electrode and also coupled to the semiconductive channel.

The second transistor includes a first current terminal; a second current terminal; a semiconductive channel coupled between the first current terminal and the second current terminal; a gate electrode disposed between the first current terminal and the second current terminal and coupled to the semiconductive channel and configured to modulate an output of the transistor in response to the RF input signal; and a field plate electrode that is adjacent to the gate electrode and also coupled to the semiconductive channel.

The field-plate bias circuity is coupled to the field plate electrodes of the first transistor and the second transistor and is configured to apply a desired first field plate voltage to the field plate electrode of the first transistor and to apply a desired second field plate voltage to the field plate electrode of the second transistor. The desired first and second field plate voltages are configured to at least partially deplete the channel regions of the first transistor and the second transistor of charge carriers near the field plate electrodes of the first and second transistors, respectively.

Example 16: The device or method of Example 15, where the field plate bias circuitry is powered by the amplified signal at the output node of the device.

Example 17: A device or method of forming a device that includes an input node configured to receive a radiofrequency (RF) input signal; an output node configured to output an amplified signal corresponding to the RF input signal; a transistor configured to amplify the RF input signal; and field-plate bias circuity.

The transistor includes a first current terminal; a second current terminal; a semiconductive channel coupled between the first current terminal and the second current terminal; a gate electrode disposed between the first current terminal and the second current terminal and coupled to the semiconductive channel and configured to modulate an output of the transistor in response to the RF input signal; and a field plate electrode that is adjacent to the gate electrode and also coupled to the semiconductive channel.

The field-plate bias circuity coupled to the field plate electrode and configured to apply a desired field plate bias voltage to the field plate electrode that at least partially depletes the channel region of charge carriers near the field plate electrode.

Example 18: The device or method of Example 17, where the second current terminal is coupled to a reference potential node ("ground node") and the transistor is a depletion mode transistor configured to operate in an 'on' state when the gate electrode is biased to a gate potential that is negative relative to the ground node. The field plate bias circuitry is configured to bias the field plate electrode to a field plate potential that is negative relative to a potential of the ground node and different from the gate potential.

Example 19: The device or method of Example 18 where the field plate potential is more negative than the gate potential relative to the potential of the ground node.

Example 20: The device or method of Example 17, where the second current terminal is coupled to a reference potential node ("ground node") and the transistor is a depletion mode transistor configured to operate in an 'on' state when the gate electrode is biased to a gate potential that is positive relative to the ground node. The field plate bias circuitry is configured to bias the field plate electrode to a field plate potential that is positive relative to the potential of the ground node and different from the gate potential.

Example 21: The device or method of Example 20 where the field plate potential is more positive than the gate potential relative to the potential of the ground node.

Example 22: The device or method of Example 17 where the second current terminal is coupled to a reference potential node ("ground node"). The transistor is an enhancement mode transistor configured to operate in an 'on' state when the gate electrode is biased to a gate potential that is positive relative to the ground node; and the field plate bias circuitry is configured to bias the field plate electrode to a field plate potential that is negative relative to a potential of the ground node.

Example 23: The device or method of Example 17 where the second current terminal is coupled to a reference potential node ("ground node"). The transistor is an enhancement mode transistor configured to operate in an 'on' state when the gate electrode is biased to a gate potential that is negative relative to the ground node; and the field plate bias circuitry is configured to bias the field plate electrode to a field plate potential that is positive relative to the potential of the ground node.

The preceding detailed description and examples are merely illustrative in nature and are not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

It should be understood that this invention is not limited in its application to the details of construction and the arrangement of components set forth in the preceding description or illustrated in the accompanying drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The preceding discussion is presented to enable a person skilled in the art to make and use embodiments of the invention. Various modifications to the illustrated embodiments will be readily apparent to those skilled in the art, and the generic principles herein can be applied to other embodiments and applications without departing from embodiments of the invention. Thus, embodiments of the invention are not intended to be limited to embodiments shown, but are to be accorded the widest scope consistent with the principles and features disclosed herein. The preceding detailed description is to be read with reference to the figures, in which like elements in different figures have like reference numerals. The Figures, which are not necessarily to scale, depict selected embodiments and are not intended to limit the scope of embodiments of the invention. Skilled artisans will recognize the examples provided herein have many useful alternatives and fall within the scope of embodiments of the invention.

The connecting lines shown in the various figures contained herein are intended to represent exemplary functional relationships and/or physical couplings between the various elements. It should be noted that many alternative or additional functional relationships or physical connections may be present in one or more embodiments of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in one or more embodiments of the depicted subject matter.

## Claims

1. An electronic device, comprising:
an input node and an output node;
a transistor comprising:
a first current terminal coupled to the output node ;
a second current terminal;
a semiconductive channel region disposed between the first current terminal and the second current terminal;
a gate electrode electrically coupled to the semiconductive channel region and coupled to the input node;
a field plate electrode electrically coupled to the semiconductive channel region and disposed adjacent to the gate electrode; and
field-plate bias circuity coupled to the field plate electrode and configured to apply a desired field plate bias voltage to the field plate electrode that at least partially depletes the channel region of charge carriers near the field plate electrode.

2. The device of claim 1 wherein the field plate electrode is disposed between the gate electrode and the first current terminal.

3. The device of claim 1,
wherein the field plate bias circuitry is coupled between the second current terminal and the output node;
wherein the field plate bias circuitry is configured to generate the field plate bias voltage to the field plate electrode in response to a time-varying voltage at the output node.

4. The device of claim 3, wherein the field plate bias circuitry includes a charge pump circuit that is powered by the time-varying voltage at the output node and configured to generate the desired field plate bias voltage.

5. The device of claim 3, wherein the transistor and at least part of the field plate bias circuitry are integrally formed within semiconducting material of a single semiconductor substrate.

6. The device of Claim 3, wherein the field plate bias voltage is generated by the field plate bias circuitry in response to the time-varying voltage at the output node having at least a predetermined minimum amplitude.

7. The device of claim 1 wherein the transistor includes at least:
first and second drain fingers coupled to the first current terminal;
first and second source fingers coupled to the second current terminal;
first and second gate fingers coupled to the first control terminal; and
first and second field plate fingers; and
wherein the field plate bias circuitry comprises:
a first field plate bias circuit coupled to the first field plate finger and configured to supply a first predetermined field plate finger bias voltage to the first field plate finger; and
a second field plate bias circuit coupled to the second field plate finger and configured to supply a second field plate finger bias voltage to the second field plate finger.

8. The device of claim 7, wherein the first field plate finger bias voltage is equal to the second field plate finger bias voltage.

9. The device of claim 7,
wherein the first field plate bias circuit includes an input capacitance that couples the first drain finger to the first field plate bias circuit.

10. The device of claim 7,
wherein the first field plate bias circuit includes an output capacitance coupled between the first source finger and the first field plate finger;
wherein the output capacitance of the first bias field plate bias circuit has a first capacitor terminal formed by at least a portion of the first source finger.

11. The device of claim 1, wherein the transistor is a high electron mobility transistor, HEMT, and the channel region comprises a semiconductor heterostructure configured to form a two-dimensional electron gas (2DEG) at a buried semiconductor heterojunction within the semiconductor heterostructure.

12. The device of claim 1, wherein field plate bias circuitry comprises:
an input capacitance and an output capacitance;
wherein the input capacitance is coupled between the first current terminal and the output capacitance;
wherein the output capacitance is coupled between the output node of the field plate bias circuitry and a reference potential node.

13. The device of claim 12, wherein field plate bias circuitry further comprises:
voltage regulation circuitry is configured to prevent a magnitude of a voltage across the output capacitance from exceeding the desired field plate bias voltage.

14. The device of claim 13, wherein the field plate bias circuitry is configured to cause an electric potential of the field plate electrode to be lower than respective electric potentials of the first current terminal, the second current terminal, and the gate electrode.

15. A Doherty amplifier comprising an electronic device as claimed in any preceding claim:
wherein the input node is configured to receive a radiofrequency (RF) input signal;
wherein the output node is configured to output an amplified signal corresponding to the RF input signal;
the Doherty amplifier comprising: a carrier amplifier signal path that includes
a first transistor, being the transistor according to any preceding clam, and configured to amplify the RF input signal over a first input power range of the RF input signal; and
a peaking amplifier signal path that includes:
a second transistor configured to further amplify the RF input signal over a second input power range of the RF input signal, wherein the second transistor comprises:
a first current terminal;
a second current terminal;
a semiconductive channel coupled between the first current terminal and the second current terminal;
a gate electrode disposed between the first current terminal and the second current terminal and coupled to the semiconductive channel and configured to modulate an output of the transistor in response to the RF input signal;
a field plate electrode that is adjacent to the gate electrode and also coupled to the semiconductive channel; and
field-plate bias circuity coupled to the field plate electrodes of the first transistor and the second transistor;
wherein the field plate bias circuitry is configured to apply a desired first field plate voltage to the field plate electrode of the first transistor and to apply a desired second field plate voltage to the field plate electrode of the second transistor; and
wherein the desired first and second field plate voltages are configured to at least partially deplete the channel regions of the first transistor and the second transistor of charge carriers near the field plate electrodes of the first and second transistors, respectively.
